# EUROPEAN PATENT APPLICATION

(11) **EP 4 811 973 A1**
(43) Date of publication of application: **23.09.2026**
(21) Application number: 25187460.8
(22) Date of filing: 04.07.2025
(51) Int. Cl.: H10F 77/20, H10F 71/00

(54) **SOLAR CELL AND METHOD FOR PREPARING THE SAME**

(30) Priority: 18.03.2025 CN 202510317060
(71) Applicant: Jinko Solar (Haining) Co., Ltd., Haining City, Zhejiang (CN)
(72) Inventor: WANG, Yunpeng, Haining City (CN); QIU, Yankai, Haining City (CN); ZHOU, Jing, Haining City (CN); LI, Guojian, Haining City (CN); GE, Tao, Haining City (CN)
(74) Representative: Balder IP Law, S.L.

(57) **Abstract**

Provided are a solar cell and a method for preparing the same. The solar cell includes a substrate, and a first gridline structure and second gridline structures located on the substrate. The first gridline structure includes first gridlines spaced apart in a first direction, and intermediate gridlines between two adjacent first gridlines. Each first gridline extends in a second direction intersecting with the first direction. The intermediate gridlines are spaced apart in the second direction, and each intermediate gridline is spaced apart from the two adjacent first gridlines. The second gridline structures are spaced apart along the first direction. Each second gridline structure includes second gridlines spaced apart along the second direction, and each second gridline extends along the first direction. The second gridlines intersect with the same first gridline, and two adjacent second gridlines along the first direction are electrically connected to each other via a respective intermediate gridline.

## Description

### TECHNICAL FIELD

The various embodiments described in this document relate to the field of photovoltaic power generation, and in particular, to a solar cell and a method for preparing the same.

### BACKGROUND

With the continuous advancement of new energy power generation technologies, the proportion of new energy in electricity production is increasing. New energy offer diverse acquisition pathways and generate no environmentally polluting impacts. Photovoltaic power generation harnesses solar radiation to produce electricity through solar cells. These solar cells operate based on the photovoltaic effect, which generates electric current when exposed to sunlight.

During the preparation of a solar cell, a screen printing process is employed. In the screen printing process, an electrode paste is deposited through a patterned screen stencil to form gridline structures. The gridline structures are critical components of the solar cell, functioning to collect and transport electrons. The screen stencil is designed according to the form of the gridline structures. The characteristics of the gridline structures formed by the screen printing process affect the welding effect in the subsequent component welding processes, with suboptimal designs leading to solder gridline fracture. Therefore, how to design the form of the gridline structures to mitigate solder gridline fracture is desired.

### SUMMARY

Embodiments of the present disclosure provide a solar cell and a method for preparing the same, which can mitigate the occurrence of solder gridline fracture.

To achieve the above objective, the embodiments of the present disclosure provide a solar cell. The solar cell includes a substrate, and a first gridline structure and a plurality of second gridline structures located on the substrate. The first gridline structure includes a plurality of first gridlines spaced apart in a first direction, and a plurality of intermediate gridlines between two adjacent first gridlines. The plurality of first gridlines extend in a second direction intersecting with the first direction. The plurality of intermediate gridlines are spaced apart in the second direction, and a respective intermediate gridline is spaced apart from the two adjacent first gridlines. The plurality of second gridline structures are spaced apart along the first direction. A respective second gridline structure of the plurality of second gridline structures includes a plurality of second gridlines spaced apart along the second direction, extending along the first direction and intersecting with one respective first gridline of the plurality of first gridlines. Two adjacent second gridlines along the first direction are electrically connected to each other via a respective intermediate gridline.

The embodiments of the present disclosure further provide a method for preparing the solar cell described above. The method includes: providing the substrate; printing the first gridline structure on a surface of the substrate by using a first screen stencil, where the first screen stencil is provided with first apertured slots spaced apart in the first direction and a plurality of second apertured slots between two adjacent first apertured slots, the first apertured slots extend in the second direction, and the plurality of second apertured slots are spaced apart in the second direction; and printing the plurality of second gridline structures on the surface of the substrate by using a second screen stencil, where the second screen stencil is provided with a plurality of printing zones spaced apart in the first direction, a respective printing zone of the plurality of printing zones is provided with a plurality of third apertured slots spaced apart in the second direction and extending in the first direction, and a gap zone between adjacent printing zones along the first direction is aligned with a respective second apertured slot.

### BRIEF DESCRIPTION OF THE DRAWINGS

One or more embodiments are exemplarily described with reference to the corresponding figures in the accompanying drawings, and the descriptions are not to be construed as limiting the embodiments. Elements in the accompanying drawings that have same reference numerals are represented as similar elements, and unless otherwise particularly stated, the figures in the accompanying drawings are not drawn to scale.
FIG. 1 is a schematic diagram of a gridline pattern in a solar cell adopting a conventional gridline form in some cases.
FIG. 2 is a partially enlarged schematic diagram of the gridline pattern shown in FIG. 1.
FIG. 3 is a schematic diagram of busbars in the gridline pattern shown in FIG. 1.
FIG. 4 is a partially enlarged schematic diagram of the busbars in the gridline pattern shown in FIG. 1.
FIG. 5 is a schematic diagram of fingers in the gridline pattern shown in FIG. 1.
FIG. 6 is a partially enlarged schematic diagram of the fingers in the gridline pattern shown in FIG. 1.
FIG. 7 is a schematic diagram of a solar cell according to some embodiments of the present disclosure.
FIG. 8 is a schematic diagram of a gridline pattern in a solar cell according to some embodiments of the present disclosure.
FIG. 9 is a partially enlarged schematic diagram of the gridline pattern shown in FIG. 8.
FIG. 10 is a schematic diagram of a first gridline structure in the gridline pattern shown in FIG. 8.
FIG. 11 is a partially enlarged schematic diagram of the first gridline structure in the gridline pattern shown in FIG. 8.
FIG. 12 is a schematic diagram of a second gridline structure in the gridline pattern shown in FIG. 8.
FIG. 13 is a partially enlarged schematic diagram of the second gridline structure in the gridline pattern shown in FIG. 8.
FIG. 14 is a schematic diagram of a structure of an intermediate gridline in the gridline pattern shown in FIG. 8.
FIG. 15 is a schematic diagram of a structure of a transition segment of a second gridline in the gridline pattern shown in FIG. 8.

### DETAILED DESCRIPTION OF THE EMBODIMENTS

To make the objects, technical solutions and advantages of the present disclosure clearer, embodiments of the present disclosure are described in detail below in conjunction with the accompanying drawings. Those of ordinary skill in the art should appreciate that in embodiments of the present disclosure, numerous technical details have been presented to enable better understanding of the present disclosure. However, even without these technical details and various variations and modifications based on the following embodiments, the technical solutions claimed in the present disclosure can be realized. The division of the following embodiments is for descriptive convenience only and shall not be construed as limiting the implementation of the present disclosure, and various embodiments can be combined or cross-referenced without logical contradiction

Unless otherwise expressly defined herein, all technical and scientific terms used throughout this specification shall be construed in accordance with their commonly accepted meanings within the art to which this application pertains. The terminology employed herein is solely for the purpose of describing specific embodiments and is not intended to limit the scope of the present disclosure. The terms "comprises," "comprising," "has," "having," and any grammatical variants thereof, as used in the description, claims, and figure descriptions of this application, are intended to specify the presence of stated features, steps, or components, but do not preclude the addition of one or more unrecited elements.

In the description of the embodiments of the present disclosure, unless otherwise specified and limited, technical terms "mounted," "connected," "connecting," "fixed," etc. are to be understood in a broad sense. For example, it may be a fixed connection, a removable connection, or a one-piece connection, it may be a mechanical connection, or an electrical connection, it may be a direct connection, or an indirect connection through an intermediate medium, and it may be a connection between two elements or an interaction between the two elements. For those of ordinary skill in the art, specific meanings of the above terms in the embodiments of the present disclosure may be understood according to specific situations.

With the continuous development of solar cell preparation technology, the photoelectric conversion efficiency of solar cells is also continuously improved. In the preparation of solar cells, a screen printing process is experienced. The screen printing process forms a gridline electrode on the surface of the solar cell. The gridline can be divided into a busbar and a finger. According to the number of busbars, the solar cell can be divided into a super multi-busbar (SMBB) cell, a multi-busbar cell and a 0BB (0BB means no busbar) cell. The busbar usually intersects the finger perpendicularly, and the gridline electrode can be formed on one side or both sides of the solar cell. Screen printing is performed by using a screen stencil, and the screen stencil is designed with openings for printing metal paste, which is usually silver paste. The metal paste is printed on the surface of the cell to form a busbar or a finger, and the desired electrode pattern is obtained after sintering or drying and curing.

The full-aperture steel screen stencil is a screen stencil with 100% opening rate. The main body is no longer woven by steel wires, but uses an alloy steel sheet, and the printing opening is obtained by laser slotting. The opening rate of the screen printing work area reaches 100%, that is, all the printing patterns are not blocked by steel wires or other similar structures. Since the full-aperture steel screen stencil has no any screen yarn blocking in the slotting area, the transmittance of the paste can be greatly improved, and the consumption of the paste is saved. At the same time, the screen printing using the full-aperture steel plate screen can optimize the width of the gridline, and greatly reduce the shading area of the cell surface. In addition, the height of the gridline after the full-aperture steel plate screen printing is uniform and flat, and the fluctuation degree is significantly lower than that of the traditional screen printing. The resistance of the gridline can be significantly reduced, and the fill factor of the solar cell is improved.

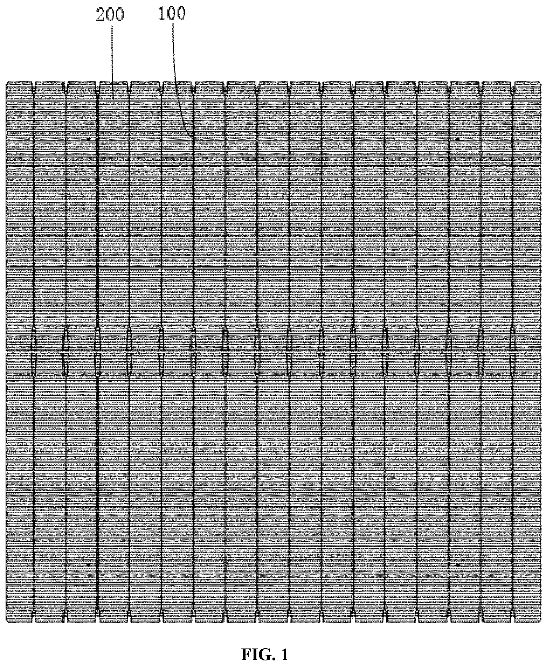

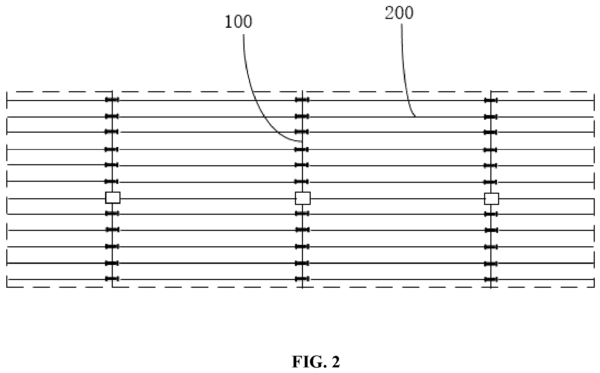

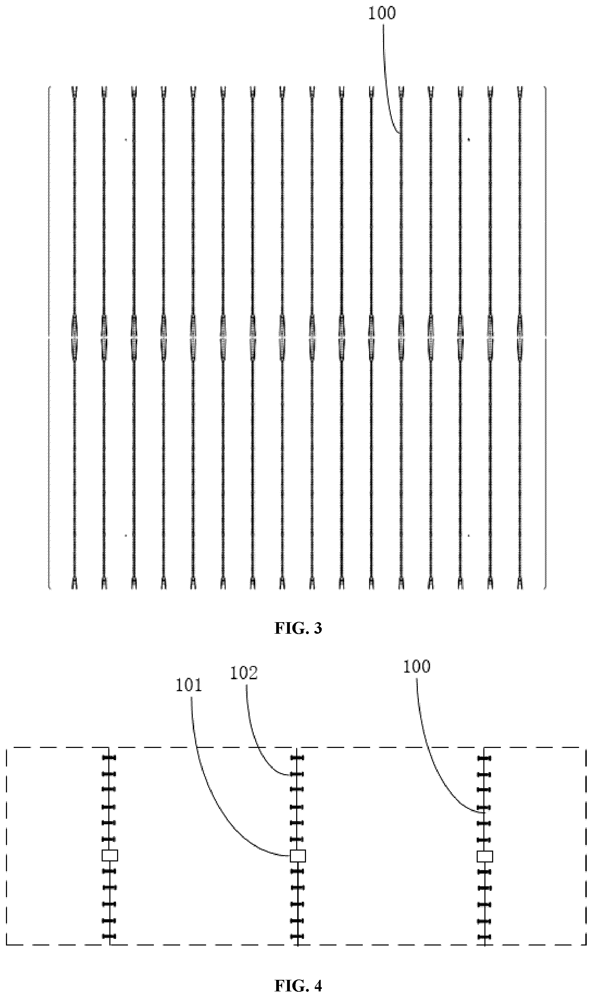

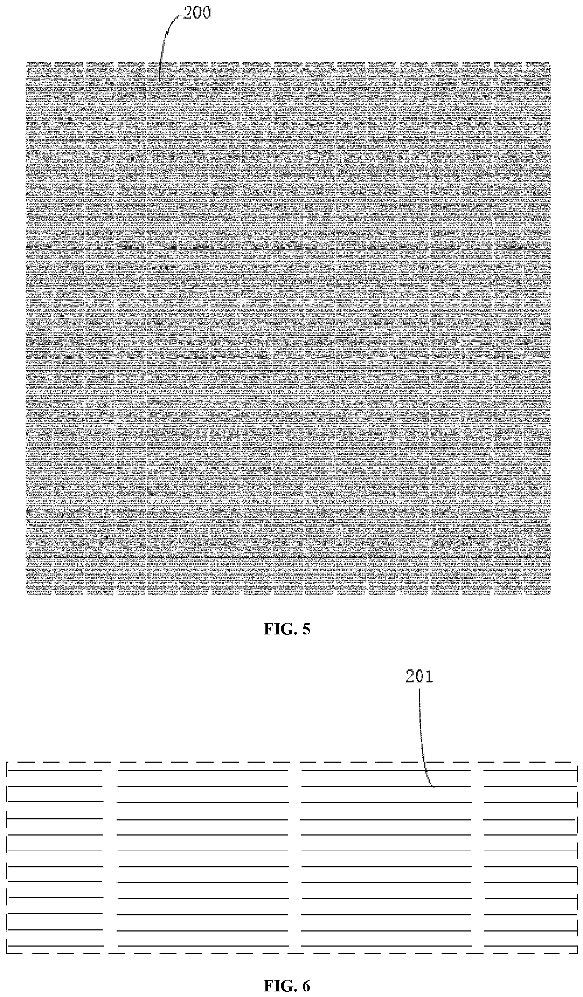

However, the current full-aperture steel plate screen printing plate is mainly used for small-size heterojunction cells and the metallization printing of 0BB cells with special component welding process. When the full-aperture steel plate screen printing plate is applied to multi-busbar cells, such as mainstream SMBB cell products, the molding requirement at the busbar bridging/welding position does not match the SMBB cell product, and abnormal problems such as component welding broken busbar and poor overlap occur. Table 1 below shows the molding comparison of the SMBB cell product at the busbar bridging/welding position in the case of using a conventional Polyimide (PI) screen printing plate and using a full-aperture steel plate screen printing plate for the conventional gridline form design. The conventional gridline form is shown in FIGS. 1 and 2, and the solar cell adopts a form of gradual change or an I-shaped design on the busbar 100, and the finger 200 overlaps the busbar 100. FIGS. 3 and 4 show the structure of the busbar 100 in the conventional gridline form, and the busbar 100 includes a busbar connection line, a main bonding pad 101 for welding a welding strip on the busbar connection line, and a bridging/welding portion 102. FIGS. 5 and 6 show the structure of the finger 200 in the conventional gridline form, and the finger 200 includes a plurality of finger connection lines. The thickness of the screen printing plate used in the comparison test is 18.5 µm, and the opening width of the slot is 40 µm.

**Table 1, comparison of profile characteristics of the solar cell at the bridging/welding portion when different screen stencils are used to make gridline electrodes**

| Parameters | Conventional PI screen stencil | Full-Aperture steel screen stencil |
|---|---|---|
| Height (µm) | 8.5 | 3.5 |
| Width (µm) | 55.4 | 65.5 |
| Aspect Ratio (H/W ×100%) | 15.3% | 5.3% |

As can be seen, the conventional gridline form design of the SMBB cell product has a low molding height performance when using the full-aperture steel plate screen printing plate, which causes welding fusing in the process of welding the welding strip of the component, thereby causing the current loop to be broken, which is shown as EL (Electroluminescence) blackening, and is called welding broken busbar. That is, the full-aperture steel plate screen printing plate does not match the process of the current SMBB cell product, and the gridline form needs to be optimized to ensure the molding effect at the position of the welding part of the busbar welding strip. That is, the gridline form of the multi-busbar cell needs to be designed, so that the full-aperture steel plate screen printing plate pattern based on the multi-busbar cell product can adapt to the process of the multi-busbar cell product, and the problem of welding broken busbar is solved.

In order to reduce the welding broken grid phenomenon of the solar cell after adopting the full-aperture steel plate screen printing process, some embodiments of the present disclosure provide a solar cell. The gridline form of the solar cell is optimized and designed, the printing of the busbar welding part is shaped and optimized, and the overlap position of the finger connecting line is transferred to between the adjacent two busbars. When screen printing is performed, the high plasticity of the electrode paste corresponding to the finger is utilized to ensure the shaping effect at the intersection of the finger and the busbar, i.e., the position of the busbar welding part. The design scheme can solve the welding broken grid problem when the full-aperture steel plate screen printing technology is applied to the multi-main-grid cell product, and does not affect the efficiency wet weight, and can realize more precise image display refinement and more accurate alignment. In terms of efficiency, the shading ratio can be ensured to be consistent with the conventional gridline form. In terms of wet weight, the actual printing shape can be fitted by designing the screen printing parameters, that is, the actual printing shape is monitored for a long time, the expected wet weight of the scheme is fitted, and the screen printing design parameters are adjusted.

It should be noted that, in order to adapt to the functional characteristics of different gridlines, when the screen printing process is performed, the electrode paste used for printing the busbar is different from the electrode paste used for printing the auxiliary grid, and has respective required components and proportions. The busbar paste is usually only used for ensuring welding tension, and has a lower requirement on the shaping ability of the paste itself. The finger paste usually has a good shaping ability, good sintering characteristics and ohmic contact characteristics. When the full-aperture steel plate screen printing process is performed, the busbar has a plasticity obviously lower than that of the finger due to a good paste transmittance. That is, when the solar cell adopts the conventional gridline form, the busbar bridging/welding part and the busbar connecting line are printed by the busbar paste, and the plasticity is poor. In the actual situation, considering the paste development cost, the overlap position on the busbar connecting line, i.e. the discontinuous position of the finger connecting line, is transferred to between the adjacent two busbars without changing the original paste system. Thus, the finger connecting line completely passes through the busbar, the finger paste is printed at the position of the busbar welding part, and the shaping effect at the position of the busbar welding part is ensured. By adopting the optimized gridline pattern design, the cost is reduced and the efficiency is improved.

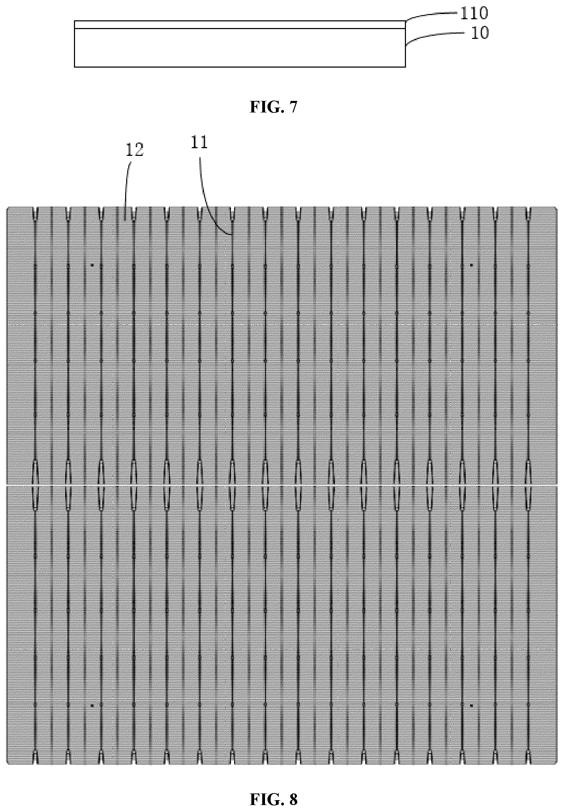

The structure of the solar cell according to some embodiments of the present disclosure is described below in combination with FIGS. 7 to 15.

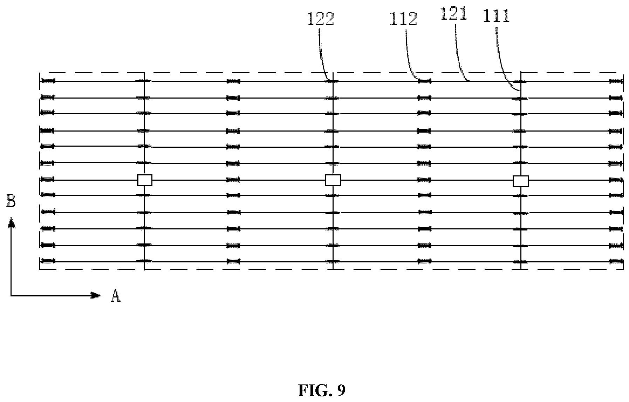

As shown in FIGS. 7 to 15, the solar cell according to some embodiments of the present disclosure includes a substrate 10, and a first gridline structure 11 and a plurality of second gridline structures 12 on a surface of the substrate 10. The first gridline structure 11 includes a plurality of first gridlines 111 spaced apart in a first direction (i.e., a direction indicated by arrow A in FIG. 9), and a plurality of intermediate gridlines 112 between two adjacent first gridlines 111.

A respective first gridline extends in a second direction (i.e., a direction indicated by arrow B in FIG. 9) intersecting with the first direction. The plurality of intermediate gridlines 112 are spaced apart in the second direction, and a respective intermediate gridline 112 is spaced apart from the two adjacent first gridlines 111. The plurality of second gridline structures 12 are spaced apart along the first direction. A respective second gridline structure 12 includes a plurality of second gridlines 121 spaced apart along the second direction, and a respective second gridline 121 extends along the first direction. The plurality of second gridlines in the respective second gridline structure 12 intersect with the same first gridline, and second gridlines 121 in a same second gridline structure 12 are electrically connected to respective second gridlines 121 in an adjacent second gridline structure 12 via respective intermediate gridlines 112 between the same second gridline structure 12 and the adjacent second gridline structure 12.

The substrate 10 is the base for forming the gridline electrodes of the solar cell, and is usually a silicon substrate. The front and back surfaces of the substrate 10 can be printed with metal paste to form gridline electrodes with specific patterns. The gridline electrodes printed on the front surface of the substrate 10 are front electrodes 110, and the gridline electrodes printed on the back surface of the substrate 10 are back electrodes. Usually, the front surface of the substrate 10 is the light receiving surface, receiving solar energy from directly incident light, and the back surface of the substrate 10 is the back light receiving surface, receiving solar energy from scattered and refracted light. The gridline electrodes can be printed on one or both surfaces of the substrate 10 to form a single-sided cell or a double-sided cell. FIG. 7 illustrates a single-sided cell. FIGS. 8 and 9 show the gridline patterns on the surface of the solar cell.

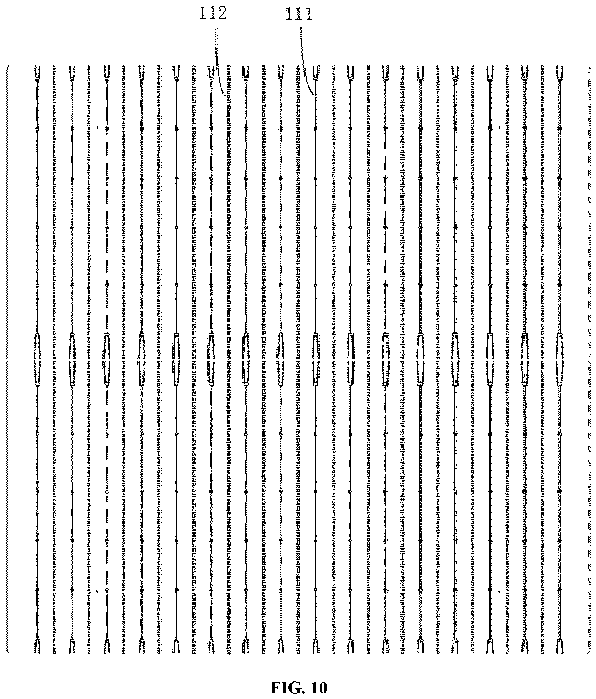

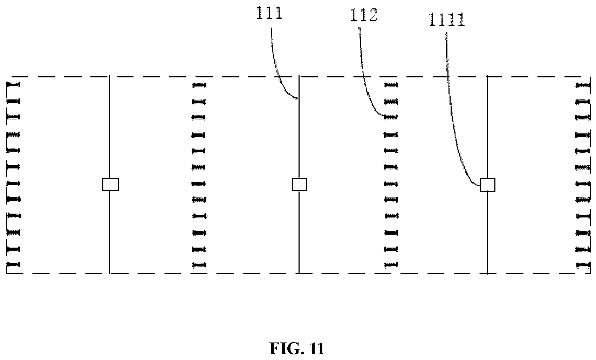

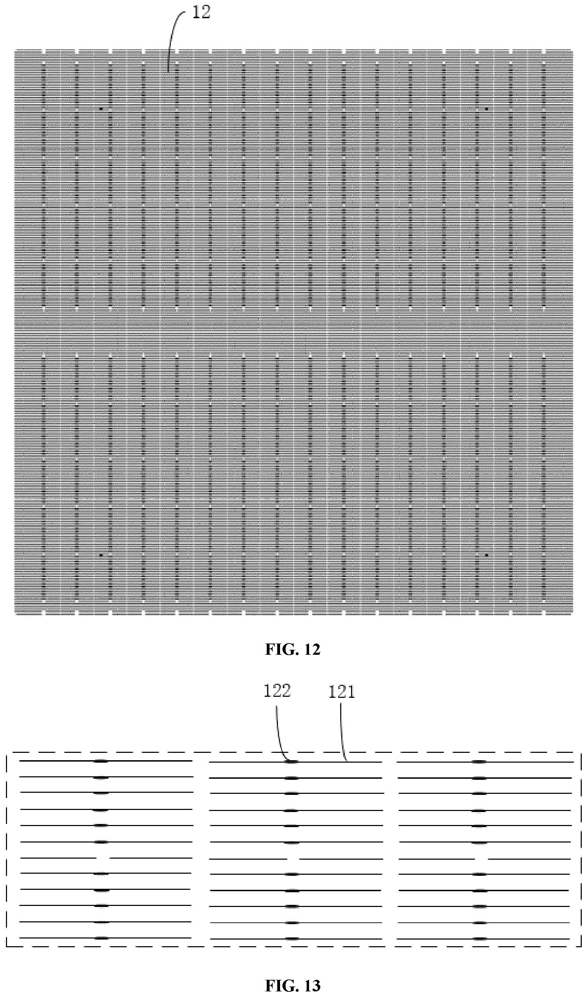

The first gridline structure 11 and the second gridline structure 12 are formed on different regions of the surface of the substrate 10. FIG. 10 and FIG. 11 show the first gridline structure 11, and FIG. 12 and FIG. 13 show the second gridline structure 12. The first gridline structure 11 and the second gridline structure 12 can be formed by printing using different screens to form the busbar and the finger on the surface of the solar cell. In the different gridline structures, the first gridline 111 forms the busbar of the solar cell, and the busbar is provided with a bonding pad 1111. The second gridline 121 is connected by the intermediate gridline 112 to form the finger of the solar cell. The second gridline 121 can pass through the bonding pad 1111 or cannot pass through the bonding pad 1111. The second gridline 121 passing through the bonding pad 1111 can include two disconnected parts, and the two disconnected parts are connected by the bonding pad 1111 to form a channel. The busbar and the finger are spaced apart on the surface of the substrate 10, and the extension directions of the busbar and the auxiliary grid, i.e., the first direction and the second direction, can be two directions perpendicular to each other or two directions with other included angles. The intermediate gridline 112 and the second gridline 121 on both sides are in one-to-one or one-to-many correspondence, i.e., one intermediate gridline 112 can be connected with only one second gridline 121 or can be connected with a plurality of second gridlines 121 at one end. The intermediate gridline 112 and the second gridline 121 are arranged in the same direction, and the second gridline 121 can be overlapped on the intermediate gridline 112 during printing. Thus, the intermediate gridline 112 connects the disconnected second gridlines 121 to form a complete auxiliary grid, thereby ensuring the formation of a channel for electron movement. In actual cases, the number of the busbar can be 9, 12, 13, 15, 16, 18, or 20. The number of the finger can be 45, 50, 55, 60, 65, 70, or 75. In addition, the solar cell according to some embodiments of the present disclosure can be a whole cell or can be constructed in the form of a half cell, and the half cell is formed by dividing a whole cell into two halves along a direction perpendicular to the busbar.

The solar cell according to some embodiments of the present disclosure is designed with a first gridline structure 11 and a second gridline structure 12 on the surface of a substrate 10. The first gridline 111 of the first gridline structure 11 forms a busbar, and a plurality of intermediate gridlines 112 arranged along the extension direction of the first gridline 111 are located between two adjacent first gridlines 111. The second gridlines 121 of the plurality of second gridline structures 12 are connected through the intermediate gridlines 112 to form a secondary grid. The plurality of second gridlines 121 of a single second gridline structure 12 are arranged to cross the same first gridline 111. Thus, the overlap position of the secondary grid connection line is shifted to between two adjacent busbars. The characteristics of the secondary grid paste can be used to ensure the molding effect at the position of the busbar welding part, thereby reducing the welding grid breakage phenomenon.

When the screen printing process is performed by using a full-aperture steel mesh plate, the overlap position of the secondary grid connection line is shifted to between two adjacent busbars, because the busbar and the intermediate gridline 112 connecting the second gridline 121, i.e., the secondary grid connection line, are designed separately. When the second gridline 121 of the secondary grid is printed, the second gridline 121 can pass through the busbar and cross the busbar. That is, the overlap part at the welding ribbon of the busbar in the conventional design is shifted to between two adjacent busbars. The secondary grid paste can cover the welding part of the busbar. The plasticity of the secondary grid paste is better than that of the busbar paste, so that the molding effect at the position of the welding ribbon of the busbar is ensured, and the molding height is improved. Thus, the welding effect of the solar cell in the subsequent welding process is ensured, and the problem of welding grid breakage of the module caused by the low molding height at the welding position when the conventional gridline is printed by using the full-aperture steel mesh plate is avoided.

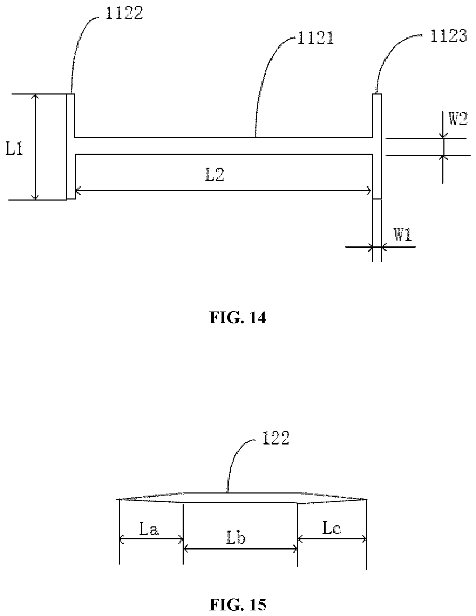

As shown in FIG. 14, a single intermediate gridline 112 can include an intermediate part 1121 extending along the first direction, and a first overlap part 1122 and a second overlap part 1123 located at the ends of the intermediate part 1121. The first overlap part 1122 and the second overlap part 1123 are connected with the second gridlines 121 in different second gridline structures 12.

The intermediate gridline 112 includes a plurality of portions, each of which plays a different role. The central segment 1121 is a longer portion of the intermediate gridline 112, and forms a main structure of the intermediate gridline 112. The central segment 1121 can ensure the overall length of the intermediate gridline 112, and ensure that two adjacent second gridlines 121 in the auxiliary gate can still be connected to form an entirety via the intermediate gridline 112 at a certain distance. The central segment 1121 has the same extension direction as the second gridline 121, and can play a connecting role between the two adjacent second gridlines 121. The central segment 1121 can be provided with a smaller width to form a narrower strip shape to reduce the light shielding area and ensure the smoothness of the electron transmission path while ensuring the connecting effect.

The first bridging portion 1122 and the second bridging portion 1123 are portions for providing an overlap basis for different second gridlines 121. The first bridging portion 1122 and the second bridging portion 1123 are located at two ends of the central segment 1121 and are spaced apart corresponding to two second gridlines 121 adjacent in the first direction. In actual cases, in order to ensure the connection effect between the second gridline 121 and the intermediate gridline 112, the two bridging portions of the intermediate gridline 112 can be made to exceed the two side edges of the second gridline 121 distributed in the width direction. So that the second gridline 121 can completely overlap the area where the bridging portions of the intermediate gridline 112 are located when printing.

It should be noted that, in the design of the full-aperture steel mesh plate, since the openings of the slots present 100% opening rate, an interruption part is arranged between the slots at different positions to ensure that the mesh plate is not separated into multiple parts due to the complete penetration of the slots. That is, the slot printing zone reserves an interruption part. The interruption part of the finger connecting line corresponds to the position of the intermediate gridline 112 in the first gridline structure 11.

In some embodiments, the first bridging portion 1122 and the second bridging portion 1123 can each extend in the second direction, and the length L1 of the first bridging portion 1122 and the second bridging portion 1123 in the second direction is greater than the width W2 of the central segment 1121 in the second direction.

That is, the two bridging portions of the intermediate gridline 112 can extend in the width direction of the second gridline 121. And the length L1 of the two bridging portions in the second direction is greater than the width W2 of the central segment 1121 in the second direction. By making the length L1 of the first bridging portion 1122 and the second bridging portion 1123 in the second direction greater than the width W2 of the central segment 1121 in the second direction, the two bridging portions can exceed the edge of the central segment 1121 in the width direction of the second gridline 121. Thus providing favorable conditions for the second gridline 121 to overlap the end of the intermediate gridline 112, and ensuring the connection effect between the second gridline 121 and the intermediate gridline 112.

In practice, the length L1 of the first bridging portion 1122 and the second bridging portion 1123 in the second direction can be greater than or equal to 70 µm and less than or equal to 150 µm, and the width W1 of the first bridging portion 1122 and the second bridging portion 1123 in the first direction can be greater than or equal to 10 µm and less than or equal to 20 µm.

By setting the two bridging portions in a strip shape, the range of the bridging portions can completely cover the end paste printing range of the second gridline 121 while reducing the light shielding area. The connection effect between the second gridline 121 and the intermediate gridline 112 is ensured.

Since the intermediate gridline 112 is located between the two adjacent busbars and does not undertake the function of forming the welding spot, the size of the bridging portion can be appropriately reduced and set in a smaller range. In a conventional gridline form, the area at the overlap position on the busbar is usually set to be large in order to ensure the welding area at the welding spot. In the solar cell provided in some embodiments of the present disclosure, the gridline form is optimized. The intermediate gridline 112 is away from the welding spot position on the busbar and does not undertake the function of welding the component, but only provides the overlap basis between the two adjacent second gridlines 121 to form a complete current loop. Therefore, the size can be designed in a smaller range to reduce the size and save the paste material while reducing the light shielding area. The size can also be designed in a larger range to ensure a good overlap effect with the second gridline 121. For example, the length L1 of the first bridging portion 1122 and the second bridging portion 1123 in the second direction can be 70 µm, 90 µm, 110 µm, 130 µm or 150 µm, and the width W1 of the first bridging portion 1122 and the second bridging portion 1123 in the first direction can be 10 µm, 12 µm, 14 µm, 16 µm, 18 µm or 20 µm.

In addition, the length L2 of the central segment 1121 in the first direction may be less than or equal to 650 µm.

Compared with the conventional gridline form, the improved gridline form can reduce the length dimension of the middle part 1121 of the intermediate gridline 112, so as to effectively reduce the light shielding area and ensure the photoelectric conversion efficiency of the solar cell. That is, the length L2 of the middle part 1121 in the first direction can be controlled to be within 650 µm, for example, 600 µm, 610 µm, 620 µm, 630 µm, 640 µm or 650 µm.

In some embodiments, the width W2 of the middle part 1121 in the second direction may be less than the width of the second gridline 121 in the second direction, and the width W2 of the middle part 1121 in the second direction is less than or equal to 40 µm.

The middle part 1121 is located in the middle position of the intermediate gridline 112 and can only play a role in transmitting electrons. Therefore, the width W2 of the middle part 1121 in the second direction may be less than the width of the second gridline 121 in the second direction. Meanwhile, since the middle part 1121 is not used as a welding part, the width W2 of the middle part 1121 in the second direction may be controlled to be within the range of less than or equal to 40 µm, so as to reduce the light shielding area and save the use of electrode paste.

As a contrastive illustration of the size design, in one example, the size of the busbar bridging/welding part designed in the conventional gridline form is that the length and width of the two side parts of the I-shaped part are 150 µm and 20 µm respectively, and the length and width of the middle part of the I-shaped part are 650 µm and 40 µm respectively. When the intermediate gridline 112 designed in the I-shaped part is located between the two adjacent busbars, the size of the intermediate gridline 112 can be designed as that the length and width of the two side overlap parts are 150 µm and 15 µm respectively, and the length and width of the middle extension part are 500 µm and 20 µm respectively.

In the actual situation, the first overlap part 1122 and the second overlap part 1123 may be symmetrically arranged about the middle part 1121.

That is, the first overlap part 1122 and the second overlap part 1123 are designed in the same shape and size, and the first overlap part 1122 and the second overlap part 1123 are in a symmetrical form. In this way, the printing manufacturing of the intermediate gridline 112 can be simplified, and the design of the screen plate is facilitated.

In some embodiments, each intermediate gridline 112 is equidistant from two adjacent first gridlines 111 in the first direction.

That is, the intermediate gridline 112 is located at a position of an intermediate line of the two adjacent first gridlines 111. The length of each second gridline 121 on both sides of the intersected first gridline 111 is kept consistent, facilitating the positioning when printing the gridlines.

In actual cases, the projection shapes of the first and second bridging portions 1122 and 1123 on the surface of the substrate 10 may be any one of a rectangle, a trapezoid, an ellipse, and a triangle.

The bridging portion can adopt different shapes according to actual needs. When a rectangle is adopted, the printing and manufacturing of the gridlines can be simplified, and the opening design of the screen is facilitated. When a trapezoid, an ellipse, or other gradient shapes are adopted, the overlapping effect of the second gridline 121 can be ensured, and the light shielding area can be reduced.

In some embodiments, the electrode paste of the first gridline 111 may be the same as that of the intermediate gridline 112, and the electrode paste of the first gridline 111 is different from that of the second gridline 121.

That is, the intermediate gridline 112 can be printed and manufactured by using the electrode paste of the same system as the main gate, and the screen printing process can be performed by using the same full-aperture steel plate screen. Moreover, the printing and manufacturing of the first gridline 111 and the intermediate gridline 112 can be simultaneously completed, and the printing and manufacturing process of different gridlines is simplified. The second gridline 121 can be printed and manufactured by using the electrode paste of the auxiliary gate, and the soldering point shaping effect of the main gate welding position is ensured.

As shown in FIGS. 13 and 15, the middle part of the second gridline 121 can have a transition segment 122 connected with the first gridline 111, and at least part of the transition segment 122 gradually increases in width in the second direction in the direction close to the connected first gridline 111.

The transition segment 122 designed on the second gridline 121 can be printed and manufactured by using the electrode paste of the auxiliary gate, and has better plasticity. Meanwhile, the transition segment 122 with the changing width can form a good welding base for the main gate welding portion, and the welding effect between the main gate welding portion and the solder strip is ensured.

The transition segment 122 may be located in the middle part of the second gridline 121. By designing the transition segment 122 in the middle part of the second gridline 121, the shaping of the main gate welding position can be optimized, and the welding tolerance is improved.

In addition, the length of the transition segment 122 of the second gridline 121 in the first direction may be greater than or equal to 0.6 mm and less than or equal to 1.2 mm.

The transition segment 122 is located at the position of the welding portion of the busbar, and by controlling the length of the transition segment 122, the welding effect can be ensured, the light shielding area can be reduced, and the use of electrode paste can be saved. In actual cases, the length of the transition segment 122 in the first direction may be 0.6 mm, 0.7 mm, 0.8 mm, 0.9 mm, 1.0 mm, 1.1 mm or 1.2 mm.

As shown in FIG. 15, the transition segment 122 of the finger can adopt a two-stage gradual varying form. For example, the transition segment 122 has a first section, a second section and a third section sequentially arranged in the first direction A. The first section and the third section each have a gradually varying width, and the second section has a fixed width. The length La of the first section is equal to the length Lc of the third section. In one example, the length La of the first section and the length Lc of the third section may be designed as 0.3 mm, and the length Lb of the second section may be designed as 0.37 mm. Meanwhile, the minimum width of the first section and the third section is designed as 0.01 mm, the maximum width is designed as 0.04 mm, and the width of the second section is designed as 0.04 mm. The transition segment 122 in the finger printing can ensure excellent shaping of the welding portion of the busbar, and effectively prevent the phenomenon of broken grid in the welding process of subsequent components.

The following Table 2 illustrates the comparison of the welding portion of the busbar when the full-aperture steel mesh plate is respectively applied to the conventional gridline pattern and the gridline pattern according to some embodiments of the present disclosure. The thickness of the full-aperture steel mesh plate used in the comparison test is 18.5 micrometers, and the opening width of the slot is 50 micrometers.

**Table 2, comparison of profile characteristics of the solar cell at the welding portion when different gridline forms are used**

| Parameters | Conventional gridline form | Gridline form in the embodiments of the present disclosure |
|---|---|---|
| Height (µm) | 2.7 | 7.5 |
| Width (µm) | 40 | 55 |
| Peel strength of welding strip (N) | 1.4 | 2.3 |
| Proportion of fractured gridlines | 14.3% | 0.0 |
| Bridging deviation rate | 1.1% | 0.9% |

It can be seen that the conventional gridline form design has low molding height performance when using the full-aperture steel mesh printing, which can cause a large proportion of fractured gridlines (solder gridline fracture) the welding process of the assembly. After improving the gridline form, the full-aperture steel mesh can better adapt to the gridline printing of the multi-main-grid battery product. The molding height at the welding strip position of the busbar can be greatly improved, the welding grid breakage phenomenon in the welding process of the assembly can be effectively reduced, and the welding tension of the welding strip can reach the qualified tension value. Therefore, without changing the original paste system of the busbar and the finger of the solar cell, the overlap position of the finger connecting line on the busbar, that is, the discontinuous position of the finger connecting line, is transferred to between the adjacent two busbars. Thus, the finger connecting line completely passes through the busbar, the finger paste is printed at the welding position of the busbar, and the molding effect at the welding position of the busbar can be ensured.

The application also provides a preparation method of the solar cell.

In step S110, a substrate 10 is provided.

The substrate 10 is the basis for performing a screen printing process, that is, printing the gridline electrode. The substrate 10 is usually a silicon substrate, has a photovoltaic effect, can generate current under the irradiation of sunlight, and thus generates power.

In step S120, a first screen stencil is used to print a first gridline structure 11 on the surface of the substrate 10. The first screen stencil is provided with first apertured slots spaced apart along a first direction and a plurality of second apertured slots located between adjacent two first apertured slots. Each first apertured slot extends along a second direction, and the plurality of second apertured slots are spaced apart along the second direction.

The first screen stencil is in the form of a full-aperture steel screen stencil, has an opening rate of 100%, has no any screen yarn barrier in the apertured slot area, and can ensure the transmittance of the electrode paste. The first apertured slot of the first screen stencil corresponds to the first gridline 111, that is, the printing of the busbar, and the second apertured slot corresponds to the printing of the intermediate gridline 112. The printing of the busbar and the intermediate gridline 112 can be completed synchronously or in steps. The position of the finger connecting line in the first screen stencil is transferred from the busbar to the middle of the adjacent two busbars. The full-aperture steel mesh pattern corresponding to the busbar includes a harpoon, a busbar connecting line, a bonding pad, and the intermediate gridline 112.

In step S130, the second gridline structure 12 is formed on the surface of the substrate 10 by using a second screen stencil. The second screen stencil is provided with a plurality of printing zones spaced apart along the first direction. Each printing zone is provided with a plurality of third apertured slots spaced apart along the second direction. Each third apertured slot extends along the first direction. The interval between two adjacent printing zones along the first direction is arranged to correspond to the second apertured slot.

The second screen stencil is in the form of a full-aperture steel screen stencil, has an opening rate of 100%, and has no any screen yarn barrier in the apertured slot area, so that the transmittance of the electrode slurry can be ensured. The third apertured slot of the second screen stencil corresponds to the printing and manufacturing of the second gridline 121. A plurality of second gridlines 121 located on a straight line form a finger by being overlapped on the plurality of intermediate gridlines 112. Moreover, the second gridline 121 printed and formed by the second screen stencil is crossed with the first gridline 111 printed and formed by the first screen stencil. The plasticity of the electrode slurry of the finger is high, so that the plastic effect of the welding spot at the welding position of the busbar can be ensured. Therefore, the problem of welding broken grid in the welding process of the component can be avoided. The intersection of the finger in the second screen stencil and the busbar can be designed to be gradual. The disconnection position of the finger connecting line is shifted from the overlapping position on the busbar to the middle of the two adjacent busbars. The full-aperture steel screen stencil pattern corresponding to the finger includes the finger connecting line.

In the actual situation, the solar cell can be printed and manufactured to form the gridline electrodes on both sides. In the printing and manufacturing of the gridline electrodes, a step-by-step printing process is adopted. In the preparation of the front electrode, the front busbar of the front electrode and the intermediate gridline 112 are printed and manufactured. The number of the front busbar may be 16, and the number of the bonding pads 111 on a single front busbar is 6. Then, the front finger of the front electrode is printed, and the printed substrate 10 is sintered. The preparation of the back electrode is similar to the preparation of the front electrode. The back busbar of the back electrode and the intermediate gridline 112 are printed. The number of the back busbar may be 16, and the number of the bonding pads 111 on a single back busbar is 6. Then, the back finger of the back electrode is printed, and the printed substrate 10 is sintered. In addition, the solar cell after the printing of the gridline electrodes can be cut into two pieces along the symmetry axis of the two front electrodes, and then the two pieces are connected to form a solar cell.

Those skilled in the art should appreciate that that the preceding implementations are specific embodiments for implementing the present disclosure, and in practice, various changes may be made in the form and details without departing from the scope of the embodiments of the present disclosure. Any person skilled in the art may make variations and modifications without departing from the scope of the embodiments of the present disclosure. Therefore, the protection scope of the embodiments of the present disclosure shall be defined by the appended claims.

## Claims

1. A solar cell, comprising:
a substrate (10); and
a first gridline structure (11) and a plurality of second gridline structures (12), located on the substrate (10);
wherein the first gridline structure (11) includes:
a plurality of first gridlines (111), spaced apart in a first direction (A) and extends in a second direction (B) intersecting with the first direction (A); and
a plurality of intermediate gridlines (112) between two adjacent first gridlines (111) of the plurality of first gridlines (111), wherein the plurality of intermediate gridlines (112) are spaced apart in the second direction (B), and a respective intermediate gridline (112) is spaced apart from the two adjacent first gridlines (111);
wherein the plurality of second gridline structures (12) are spaced apart along the first direction (A), a respective second gridline structure (12) includes a plurality of second gridlines (121) spaced apart along the second direction (B), extending along the first direction (A) and intersecting with one respective first gridline (111) of the plurality of first gridlines (111); and
wherein second gridlines (121) in a same second gridline structure (12) are electrically connected to respective second gridlines (121) in an adjacent second gridline structure (12) via respective intermediate gridlines (112) between the same second gridline structure (12) and the adjacent second gridline structure (12).

2. The solar cell according to claim 1, wherein a respective second gridline (121) of the plurality of second gridlines (121) includes:
a central segment (1121) extending in the first direction (A); and
a first bridging portion (1122) and a second bridging portion (1123) at respective ends of the central segment (1121);
wherein the first bridging portion (1122) and the second bridging portion (1123) are connected to respective second gridlines (121) of different second gridline structures (12).

3. The solar cell according to claim 2, wherein the first bridging portion (1122) and the second bridging portion (1123) each extend in the second direction (B), and a length (L1) of each of the first bridging portion (1122) and the second bridging portion (1123) in the second direction (B) is greater than a width (W2) of the central segment (1121) in the second direction (B);
optionally, the length (L1) of each of the first bridging portion (1122) and the second bridging portion (1123) in the second direction (B) is greater than or equal to 70 µm and less than or equal to 150 µm; and
optionally, a width (W1) of each of the first bridging portion (1122) and the second bridging portion (1123) in the first direction (A) is greater than or equal to 10 µm and less than or equal to 20 µm.

4. The solar cell according to claim 2 or 3, wherein a length (L2) of the central segment (1121) in the first direction (A) is less than or equal to 650 µm.

5. The solar cell according to any one of claims 2 to 4, wherein a width (W2) of the central segment (1121) in the second direction (B) is less than a width of the respective second gridline (121) in the second direction (B); optionally, the width (W2) of the central segment (1121) in the second direction (B) is less than or equal to 40 µm.

6. The solar cell according to any one of claims 2 to 5, wherein the first bridging portion (1122) and a second bridging portion (1123) are symmetrically disposed with respect to the central segment (1121); optionally, a projection shape of each of the first bridging portion (1122) and a second bridging portion (1123) on a surface of the substrate (10) is one of a rectangle, a trapezoid, an ellipse, and a triangle.

7. The solar cell according to any one of claims 1 to 6, wherein the respective intermediate gridline (112) is equidistant from the two adjacent first gridlines (111).

8. The solar cell according to any one of claims 1 to 7, wherein an electrode paste for forming the plurality of first gridlines (111) is the same as an electrode paste for forming plurality of intermediate gridlines (112).

9. The solar cell according to any one of claims 1 to 7, wherein an electrode paste for forming the plurality of first gridlines (111) is different from an electrode paste for forming the plurality of second gridlines (121).

10. The solar cell according to any one of claims 1 to 9, wherein a respective second gridline (121) of the plurality of second gridlines (121) includes, at its midsection, a transition segment (122) connected to the respective first gridline (111).

11. The solar cell according to claim 10, wherein at least a part of the transition segment (122) has a width along the second direction (B) that gradually increases toward the respective first gridline (111).

12. The solar cell according to claim 10 or 11, wherein a length of the transition segment (122) in the first direction (A) is greater than or equal to 0.6 mm and less than or equal to 1.2 mm.

13. The solar cell according to claim 10, wherein the transition segment (122) has a first section, a second section and a third section sequentially arranged in the first direction (A), each of the first section and the third section has a gradually varying width, and the second section has a fixed width.

14. The solar cell according to claim 13, wherein the first section and the third section have the same length.

15. The solar cell according to claim 13 or 14, wherein the gradually varying width has a minimum value of 0.01 mm and a maximum value of 0.04 mm, and the fixed width is 0.04 mm.
